# EUROPÄISCHE PATENTSCHRIFT

(11) **EP 1 021 823 B1**
(45) Veröffentlichungstag und Bekanntmachung des Hinweises auf die Patenterteilung: **28.04.2004**
(21) Anmeldenummer: 98952508.4
(22) Anmeldetag: 27.08.1998
(51) Int. Cl.: H01L 21/00

(54) **ANLAGE MIT TRANSPORTSYSTEM**
INSTALLATION WITH TRANSPORT SYSTEM
INSTALLATION AVEC SYSTEME DE TRANSPORT

(30) Priorität: 29.08.1997 DE 19737839
(43) Veröffentlichungstag der Anmeldung: 26.07.2000
(73) Patentinhaber: Infineon Technologies AG, 81669 München (DE); Ortner Lüftungs- und Klimaanlagen GmbH, 9500 Villach (AT)
(72) Erfinder: GRIESSING, Jürgen, D-85598 Baldham (DE); JARNIG, Hubert, A-9062 Moosburg (AT)
(74) Vertreter: Reinhard - Skuhra - Weise & Partner
(86) Internationale Anmeldenummer: PCT/DE1998/002516
(87) Internationale Veröffentlichungsnummer: WO 1999/012192

(56) Entgegenhaltungen:
- EP-A- 0 341 673
- DE-A- 3 630 780
- US-A- 4 986 715
- US-A- 5 344 365
- PATENT ABSTRACTS OF JAPAN vol. 018, no. 449 (M-1660), 22. August 1994 & JP 06 143067 A (SANDO YAKUHIN KK), 24. Mai 1994
- DATABASE TDB NB83046022, April 1983 "Automatic Material Handling System" XP002093692
- PATENT ABSTRACTS OF JAPAN vol. 098, no. 008, 30. Juni 1998 & JP 10 070055 A (SONY CORP), 10. März 1998
- PATENT ABSTRACTS OF JAPAN vol. 018, no. 521 (M-1681), 30. September 1994 & JP 06 179506 A (DAIFUKU CO LTD), 28. Juni 1994

## Beschreibung

Die vorliegende Erfindung betrifft eine Anlage mit einem Transportsystem gemäß dem Oberbegriff des Anspruchs 1.

Ein derartiges Transportsystem ist in der japanischen Patentanmeldung JP 06143067 A beschrieben. Dort ist ein Transportsystem zum Transport von Halbleiterprodukten zwischen Bearbeitungsanlagen in einem Gebäude vorgesehen, wobei dieses Transportsystem von den Bearbeitungsanlagen durch eine Gebäudedecke getrennt ist. Die Gebäudedecke weist dabei Öffnungen auf, in denen Zuführungen vorgesehen sind, die dem Transport zwischen dem Transportsystem und den Bearbeitungsanlagen dienen.

Moderne industrielle Produktion ist im allgemeinen durch einen hohen Grad der Automatisierung gekennzeichnet. Dies betrifft sowohl die eigentliche Bearbeitung der zu bearbeitenden Produkte als auch den Transport der zu bearbeitenden Produkte von einer Bearbeitungseinrichtung zu einer anderen. Insbesondere in der Halbleiterindustrie ist ein hoher Automatisierungsgrad unabdingbar, um international wettbewerbsfähig sein zu können.

Während der Produktion eines integrierten Halbleiterprodukts durchläuft das Produkt bis zu 600 Prozeßschritte, die zu einem großen Teil nur mit hoch spezialisierten Bearbeitungsanlagen in einer Reinraumumgebung durchgeführt werden können. Dabei sind häufig mehrere gleichartige Bearbeitungsanlagen zu einem Bearbeitungsbereich ("Bay") zusammengefaßt, wobei normalerweise mehrere Bearbeitungsbereiche zusammen in einem Stockwerk eines Fabrikgebäudes untergebracht sind.

Um nun die zu bearbeitenden Halbleiterwafer zu den einzelnen Bearbeitungsbereichen bzw. Bearbeitungsanlagen zu transportieren, sind in demselben Stockwerk des Fabrikgebäudes, in dem auch die Bearbeitungsanlagen untergebracht sind, Transportsysteme vorgesehen. Dabei kann der Transport zwischen zwei Bearbeitungsbereichen beispielsweise über schienengebundene Fahrzeuge an der Decke des Stockwerks ("Monorails") erfolgen. Häufig sind in den einzelnen Bearbeitungsbereichen Zwischenlager, so genannte "Stocker", vorgesehen, die die für den Bearbeitungsbereich bestimmten Halbleiterwafer kurzzeitig lagern können.

Der Transport der Halbleiterwafer von einem Zwischenlager zu den eigentlichen Bearbeitungsanlagen kann dann über Roboter, schienengebunde Roboter, schienengebundene Fahrzeuge am Boden des Stockwerks oder über fahrerlose Fahrzeuge ("Automated Guided Vehicles" AGV) am Boden des Stockwerks erfolgen.

Ein derartiges Transportsystem weist jedoch eine Reihe von Nachteilen auf. Zum einen ist die Transportgeschwindigkeit gering. Der Transport von einer Bearbeitungsanlagen zu einer anderen Bearbeitungsanlage kann 10 Minuten und mehr betragen. Zum anderen ist die Transportsteurungssoftware sehr komplex. So müssen Hindernisse, insbesondere die Bearbeitungsanlagen, umfahren und Transportprioritäten vergeben werden. Es kommt zu Überholvorgängen. Kreuzungen und Abzweigungen müssen berücksichtigt werden. Darüber hinaus benötigen die Zwischenlager in den Bearbeitungsbereichen große Stellflächen, die sinnvoller für die eigentliche Produktion genutzt werden könnten.

Es ist daher die Aufgabe der vorliegenden Erfindung, ein Transportsystem sowie eine Vorrichtung zur Zwischenlagerung und zum Transport von zu bearbeitenden Produkten bereitzustellen, die die genannten Nachteile der bisherigen Systeme vermeiden oder mindern.

Diese Aufgabe wird von der Anlage mit dem Transportsystem gemäß Patentanspruch 1 gelöst. Weitere vorteilhafte Ausführungsformen, Ausgestaltungen und Aspekte der vorliegenden Erfindung ergeben sich aus den Unteransprüchen der Beschreibung und den beiliegenden Zeichnungen

Erfindungsgemäß wird eine Anlage mit Bearbeitungsanlagen, einer Gebäudedecke und einen Transportsystem zum Transport von Halbleiterprodukten zwischen den Bearbeitungsanlagen im Gebäude bereitgestellt, wobei das Transportsystem von den Bearbeitungsanlagen durch eine Gebäudedecke getrennt ist und die Anlage in Öffnungen der Gebäudedecke Zuführungen zwischen dem Transportsystem und den Bearbeitungsanlagen aufweist. Die erfindungsgemäße Anlage ist dadurch gekennzeichnet, dass die Bearbeitungsanlagen zu Bearbeitungsbereichen zusammengefaßt sind und das Transportsystem entsprechend dem Bearbeitungsbereichen in Intrabereich-Transportsysteme unterteilt ist, die über die Zuführungen mit den Bearbeitungsbereichen und miteinander durch ein Interbereich-Transportsystem verbunden sind, und dass die Intrabereich-Transportsysteme jeweils einen Lagerbereich zur Zwischenlagerung der Halbleiterprodukte aufweisen.

Das Transportsystem besitzt den Vorteil, dass es baulich von den Bearbeitungsanlagen getrennt ist. Dadurch läßt sich eine deutlich höhere Transportgeschwindigkeit erzielen. Jede Position auf der Ebene des Transportsystems kann frei wählbar erreicht werden und ist jederzeit zugänglich, sollte ein Fehler auftreten. Die Komplexität der Steuerungssoftware kann deutlich vermindert werden. Auf der Ebene bzw. dem Stockwerk der Bearbeitungsanlagen können die häufig verwendeten Schienen an der Decke eingespart werden. Die Raumhöhe auf der Ebene der Bearbeitungsanlagen kann um bis zu einem Meter verringert werden. Das Design des Transportsystems vereinfacht sich, da nun nur noch geringere Reinraumbedingungen einzuhalten sind. Das Transportsystem kann aufgebaut und gewartet werden, ohne dass die Bearbeitungsanlagen in Mitleidenschaft gezogen werden. Darüberhinaus ist kann das Transportsystem leicht an jede beliebige Anordnung der Bearbeitungsanlagen angepaßt werden. Meist ist dazu nur eine Anpassung der Steuerungssoftware notwendig.

Bevorzugt ist das Transportsystem über den Bearbeitungsanlagen angeordnet ist. Bei den heute übliche Halbleiterfabriken wird das Stockwerk über dem Stockwerk, in dem die Bearbeitungsanlagen untergebracht sind, nur für die Reinluftversorgung durch sogenannte "Filter Fan Units" verwendet, so daß hier ausreichend Platz zur Verfügung steht.

Weiterhin ist bevorzugt, wenn die Zuführungen von dem Transportsystem zu den Bearbeitungsanlagen durch die Öffnungen in der Gebäudedecke als Lifte ausgebildet sind. Diese Lifte können zusätzlich als leicht zugängliche Kurzzeitzwischenlager dienen.

In dem Transportsystem ist ein Lagerbereich zur Zwischenlagerung der zu bearbeitenden Produkte vorgesehen. Auf diese Weise können die Zwischenlager in den Bearbeitungsbereichen auf der Ebene bzw. dem Stockwerk der Bearbeitungsanlagen eingespart werden. So kann jeder Bearbeitungsbereich eine oder zwei zusätzliche Bearbeitungsanlagen aufnehmen.

Bevorzugt ist dabei der Lagerbereich als ebene horizontale Fläche ausgebildet. So läßt sich auf einfache Weise ein schneller, frei wählbarer Zugriff auf die zu bearbeitenden Produkte realisieren.

Das Transportsystem ist nach Bearbeitungsbereichen unterteilt, wobei die Unterteilungen jeweils ein Intrabereich-Transportsystem aufweisen und durch ein Interbereich-Transportsystem miteinander verbunden sind. Jedes Interbereich-Transportsystem weist einen entsprechenden Lagerbereich auf. Die Zuführungen von dem Transportsystem zu den Bearbeitungsanlagen sind durch die Intrabereich-Transportsysteme erreichbar.

Weiterhin ist bevorzugt, wenn das Intrabereich-Transportsystem einen Transportkran mit einem Greifer umfaßt und das Interbereich-Transportsystem als Conveyorsystem oder als schienengebundenes System ausgebildet ist.

Bevorzugt sind die zu bearbeitenden Produkte zwischen einem ersten Ein/Ausgangsbereich, dem Lagerbereich und zumindest einem zweiten Ein-/Ausgangsbereich hin und her transportierbar sind. Die zu bearbeitenden Produkte können somit beispielsweise von dem Interbereich-Transportsystem über den jeweiligen Lagerbereich zu den Zuführungen zu den Bearbeitungsanlagen geführt werden

Die Erfindung wird nachfolgend anhand von Figuren der Zeichnung näher dargestellt. Es zeigen:
Fig. 1 eine schematische Darstellung einer erfindungsgemäßen Anlage,
Fig. 2 eine weitere schematische Darstellung der erfindungsgemäßen Anlage, und
Fig. 3 eine schematische Darstellung einer Vorrichtung zur Zwischenlagerung und zum Transport von zu bearbeitenden Produkten.

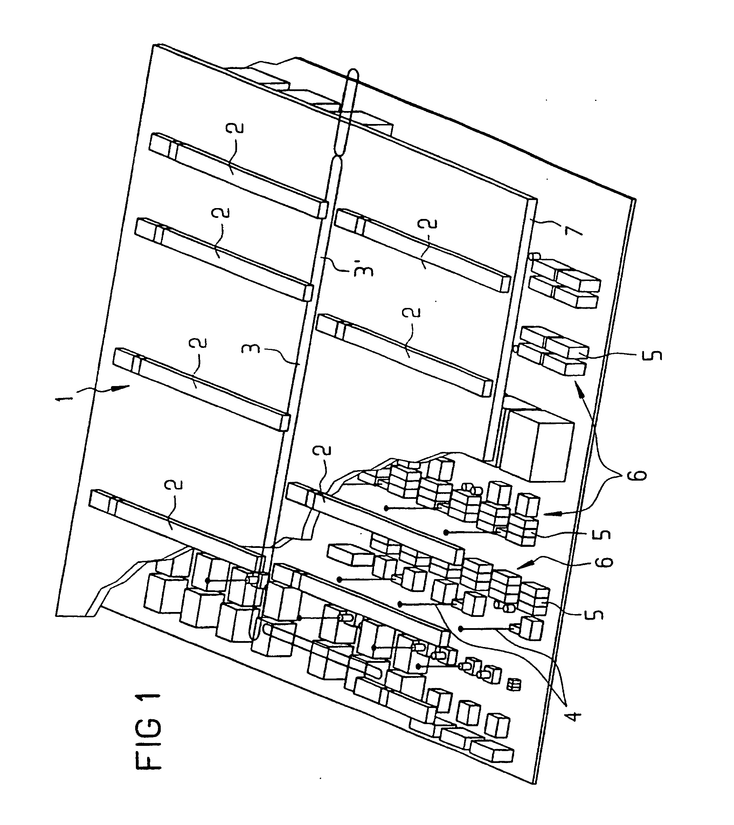

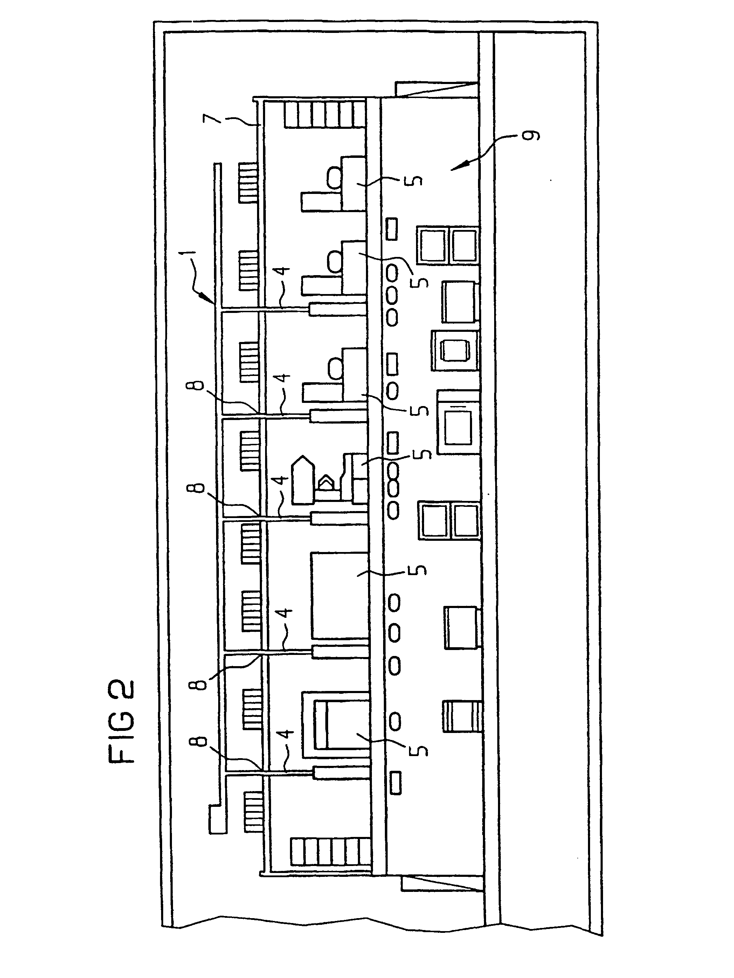

Fig. 1 zeigt eine schematische Darstellung einer erfindungsgemäßen Anlage mit Transportsystem 1. Das Transportsystem 1 ist durch eine Gebäudedecke 7 von den Bearbeitungsanlagen 5 getrennt, welche in einem Stockwerk unterhalb des Transportsystems 1 untergebracht sind. Durch Öffnungen 8 (siehe Fig. 2) in der Gebäudedecke 7 verbinden Zuführungen 4, welche als Lifte ausgebildet sind, das Transportsystem 1 mit den Bearbeitungsanlagen 5.

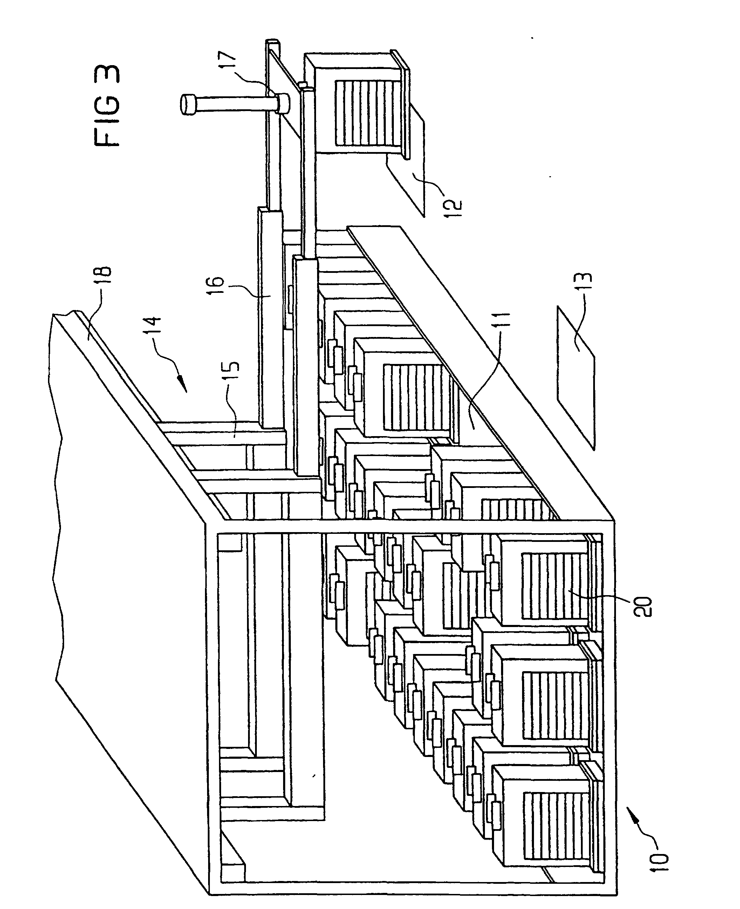

Die Bearbeitungsanlagen 5 sind zu Bearbeitungsbereichen 6 zusammengeschlossen. Dementsprechend ist auch das Transportsystem 1 in mehrere Unterteilungen 2 aufteilt. Dabei umfassen die Unterteilungen 2 jeweils eine Vorrichtung 10 zur Zwischenlagerung und zum Transport von zu bearbeitenden Produkten, wie sie mit Bezug auf Fig. 3 erläutert wird. Die Unterteilungen 2 werden durch das Interbereich-Transportsystem 3 verbunden, das schienengebundene Fahrzeuge (nicht gezeigt) auf Flurebene umfaßt.

Fig. 2 zeigt eine weitere schematische Darstellung der erfindungsgemäßen Anlage mit Transportsystem 1. Wie in Fig. 1 ist das Transportsystem 1 durch die Gebäudedecke 7 von den Bearbeitungsanlagen 5 getrennt, welche in einem Stockwerk unterhalb des Transportsystems 1 untergebracht sind. Durch die Öffnungen 8 in der Gebäudedecke 7 verbinden Zuführungen 4, welche als Lifte ausgebildet sind, das Transportsystem 1 mit den Bearbeitungsanlagen 5.

Unterhalb des Stockwerks der Bearbeitungsanlagen ist ein weiteres Stockwerk 9 vorgesehen, das weitere Unterstützungsanlagen aufnimmt.

Durch die bauliche Trennung von Transportsystem 1 und den Bearbeitungsanlagen 5 läßt sich eine deutlich höhere Transportgeschwindigkeit erzielen. Jede Position auf der Ebene des Transportsystems 1 kann frei wählbar erreicht werden und ist jederzeit zugänglich, sollte einmal ein Fehler auftreten. Wie bereits erläutert kann das Transportsystem 1 aufgebaut und gewartet werden, ohne daß die Bearbeitungsanlagen 5 in Mitleidenschaft gezogen werden. Darüberhinaus ist kann das Transportsystem 1 leicht an jede beliebige Anordnung der Bearbeitungsanlagen 5 angepaßt werden. Meist ist dazu nur eine Anpassung der Steuerungssoftware notwendig.

Fig. 3 zeigt eine schematische Darstellung einer Vorrichtung 10 zur Zwischenlagerung und zum Transport von zu bearbeitenden Produkten 20. Die Vorrichtung 10 bildet dabei einen Teil des Transportsystems 1. Die Vorrichtung 10 bildet jeweils ein Intrabereich-Transportsystem in den Unterteilungen 2 (siehe Fig. 1).

Die Vorrichtung 10 umfaßt als Transportvorrichtung einen Transportkran 14, der einen auf Schienen 18 laufenden Wagen 15 mit einen Teleskoparm 16 aufweist. Am Ende des Teleskoparms 16 ist ein Greifer 17 angebracht. Der Transportkran 14 ist über einem Lagerbereich 11 angeordnet, der als ebene, horizontale Fläche ausgebildet ist. Die zu bearbeitenden Produkte 20 sind dabei in drei Reihen in dem Lagerbereich 11 angeordnet. In diesem Fall bestehen die zu bearbeitenden Produkte 20 aus Halbleiterwafern, die in sogenannten Losen zusammengefaßt sind.

Weiterhin besitzt die Vorrichtung 10 zwei Ein/Ausgangsbereiche 12 und 13. Dabei dient der Ein/Ausgangsbereich 12 zur Übernahme von Halbleiterwafer von dem Interbereich-Transportsystem 3 (siehe Fig. 1) und der Ein/Ausgangsbereich 13 dient zur Übernahme von Halbleiterwafer von dem Lift 4, der zu den Bearbeitunganlagen 5 führt (siehe Fig. 1 oder 2).

Durch den Lagerbereich 11 können die bisher üblichen Zwischenlager in Bearbeitungsbereichen 6 eingespart werden. So kann jeder Bearbeitungsbereich 6 eine oder zwei zusätzliche Bearbeitungsanlagen 5 aufnehmen.

## Patentansprüche

1. Anlage bestehend aus Bearbeitungsanlagen (5) in einem Gebände, einer Gebäudedecke (7) und einem Transportsystem (1) zum Transport von Halbleiterprodukten (20) zwischen den Bearbeitungsanlagen (5) im Gebäude, wobei das Transportsystem (1) von den Bearbeitungsanlagen (5) durch die Gebäudedecke (7) getrennt ist und die Anlage in Öffnungen (8) der Gebäudedecke (7) Zuführungen (4) zwischen dem Transportsystem (1) und den Bearbeitungsanlagen (5) aufweist,
**dadurch gekennzeichnet,**
**dass** die Bearbeitungsanlagen (5) zu Bearbeitungsbereichen (6) zusammengefaßt sind und das Transportsystem (1) entsprechend den Bearbeitungsanlagen in Intrabereich-Transportsysteme (2,10) unterteilt ist, die über die Zuführungen (4) mit den Bearbeitungsbereichen (6) und miteinander durch ein Interbereich-Transportsystem (3) verbunden sind,
und **dass** die Intrabereich-Transportsysteme (2,10) jeweils einen Lagerbereich (11) zur Zwischenlagerung der Halbleiterprodukte (20) aufweisen.

2. Anlage nach Anspruch 1,
**dadurch gekennzeichnet,**
**daß** die zu bearbeitenden Produkte (20) in den Intrabereich-Transpcrtsystemen (10) jeweils zwischen einem ersten Ein/Ausgangsbereich (12), dem Lagerbereich (11) und zumindest einem zweiten Ein-/Ausgangsbereich (13) transportierbar sind.

3. Anlage nach Anspruch 1 oder 2,
**dadurch gekennzeichnet,**
**daß** die Lagerbereiche (11) als ebene, horizontale Flächen ausgebildet sind.

4. Anlage nach einem der Ansprüche 1 bis 3,
**dadurch gekennzeichnet,**
**dass** das Transportsystem in einem für die Reinluftversorgung vorgesehen Stockwerk über den Bearbeitungsanlagen (5) angeordnet ist.

5. Anlage nach einem der Ansprüche 1 bis 4,
**dadurch gekennzeichnet,**
**dass** die Zuführungen (4) Lifte sind.

6. Anlage nach Anspruch 5,
**dadurch gekennzeichnet,**
**dass** die Lifte (4) zusätzlich als Kurzzeitzwischenlager nutzbar sind.

7. Anlage nach einem der Ansprüche 1 bis 6,
**dadurch gekennzeichnet,**
**dass** die Intrabereich-Transportsysteme (2,10) jeweils einen Transportkran (14) mit einem Greifer (17) aufweisen.

8. Anlage nach einem der Ansprüche 1 bis 7,
**dadurch gekennzeichnet,**
**dass** die Interbereich-Transportsysteme (3) als Conveyorsystem oder als schienengebundene Systeme ausgebildet sind.

## Claims

1. Plant comprising machining plants (5) in a building, a building ceiling (7), and a transport system (1) for transporting semiconductor products (20) between the machining plants (5) in the building, the transport system (1) being separated from the machining plants (5) by the building ceiling (7) and the plant having in orifices (8) in the building ceiling (7) feeds (4) between the transport system (1) and the machining plants (5), **characterized in that** the machining plants (5) are combined to form machining zones (6) and the transport system (1) is subdivided in a way corresponding to the machining plants [sic] into intrazonal transport systems (210), which are connected via the feeds (4) to the machining zones (6) and to one another through an interzonal transport system (3), and **in that** the intrazonal transport systems (210) have in each case a storage zone (11) for the intermediate storage of the semiconductor products (20).

2. Plant according to Claim 1, **characterized in that** the products (20) to be machined can be transported in the intrazonal transport systems (10) in each case between a first entry/exit zone (12), the storage zone (11) and at least one second entry/exit zone (13).

3. Plant according to Claim 1 or 2, **characterized in that** the storage zones (11) are designed as level horizontal surfaces.

4. Plant according to one of Claims 1 to 3, **characterized in that** the transport system is arranged on a storey provided for the supply of clean air and above the machining plants (5).

5. Plant according to one of Claims 1 to 4, **characterized in that** the feeds (4) are elevators.

6. Plant according to Claim 5, **characterized in that** the elevators (4) can be additionally used as short-term intermediate stores.

7. Plant according to one of Claims 1 to 6, **characterized in that** the intrazonal transport systems (210) each have a transport crane (14) with a grab (17).

8. Plant according to one of Claims 1 to 7, **characterized in that** the interzonal transport systems (3) are designed as a conveyor system or as railborne systems.

## Revendications

1. Installation constituée d'unités de traitement (5) dans un bâtiment, d'un plafond (7) de bâtiment, et d'un système de transport (1) destiné au transport de produits semi-conducteurs (20) entre les unités de traitement (5), le système de transport (1) étant séparé des unités de traitement (5) par le plafond (7) de bâtiment, et l'installation comportant dans des ouvertures (8) du plafond (7) de bâtiment des amenées (4) entre le système de transport (1) et les unités de traitement (5),
**caractérisée en ce que**
les unités de traitement (5) sont regroupées en zones de traitement (6), et **en ce que** le système de transport (1) est subdivisé en fonction des unités de traitement en systèmes de transport intrazones (2, 10). qui sont reliés aux zones de traitement (6) par l'intermédiaire des amenées (4), et qui sont reliés entre eux par un système de transport interzones (3),
et **en ce que** chacun des systèmes de transport intrazones (2, 10) comporte une zone de stockage (11) pour le stockage intermédiaire des produits semi-conducteurs (20).

2. Installation selon la revendication 1,
**caractérisée en ce que**
les produits à traiter (20) peuvent être transportés dans les systèmes de transport intrazones (10) entre une première zone d'entrée et de sortie (12) la zone de stockage (11) et au moins une deuxième zone d'entrée et de sortie (13).

3. Installation selon la revendication 1 ou 2,
**caractérisée en ce que**
les zones de stockage (11) sont agencées en tant que surfaces horizontales planes.

4. Installation selon l'une quelconque des revendications 1 à 3,
**caractérisée en ce que**
le système de transport est disposé au-dessus des unités de traitement (5) dans un étage prévu pour l'alimentation en air pur.

5. Installation selon l'une quelconque des revendications 1 à 4,
**caractérisée en ce que**
les amenées (4) sont des élévateurs.

6. Installation selon la revendication 5,
**caractérisée en ce que**
les élévateurs (4) peuvent être utilisés de façon supplémentaire en tant que stockages intermédiaires temporaires.

7. Installation selon l'une quelconque des revendications 1 à 6,
**caractérisée en ce que**
chacun des systèmes de transport intrazones (2, 10) comporte un portique (14) avec un preneur (17).

8. Installation selon l'une quelconque des revendications 1 à 7.
**caractérisée en ce que**
les systèmes de transport interzones (3) sont agencés sous la forme de systèmes de convoyage ou de systèmes guidés sur rails.
